# EUROPEAN PATENT SPECIFICATION

(11) **EP 3 450 136 B1**
(45) Date of publication and mention of the grant of the patent: **05.08.2020**
(21) Application number: 17202510.8
(22) Date of filing: 20.11.2017
(51) Int. Cl.: B29C 64/106, B29C 64/393, B29C 64/386, B33Y 50/02, G06F 3/16

(54) **THREE-DIMENSIONAL PRINTING METHOD AND THREE-DIMENSIONAL PRINTING APPARATUS USING THE SAME**
VERFAHREN ZUM DREIDIMENSIONALEN DRUCKEN UND VORRICHTUNG ZUM DREIDIMENSIONALEN DRUCKEN UNTER VERWENDUNG DAVON
PROCÉDÉ D'IMPRESSION TRIDIMENSIONNELLE ET APPAREIL D'IMPRESSION TRIDIMENSIONNEL L'UTILISANT

(30) Priority: 29.08.2017 US 201715690207
(43) Date of publication of application: 06.03.2019
(73) Proprietor: XYZprinting, Inc., New Taipei City 22201 (TW); Kinpo Electronics, Inc., New Taipei City 22201 (TW)
(72) Inventor: YUAN, Kuo-Yen, New Taipei City 22201 (TW); LIN, Yi-Ying, New Taipei City 22201 (TW)
(74) Representative: 2K Patentanwälte Blasberg Kewitz & Reichel

(56) References cited:
- WO-A1-2017/100388
- US-A1- 2013 297 320
- Scott J Grunewald: "Bonsai Lab lauches the wordl's first voice controlled 3d printer: the sub-$500 FabPod", 3DPrint.com , 8 January 2016 (2016-01-08), XP002781162, Retrieved from the Internet: URL:https://3dprint.com/114390/bonsai-lab- fabpot-3d-printer/ [retrieved on 2016-05-18]

## Description

### BACKGROUND

### Field of the Invention

The invention is directed to a three-dimensional (3D) printer, and more particularly, to a 3D printing method that adjusts the printing parameter and a 3D printing apparatus using the 3D printing method.

### Description of Related Art

Along with the development of technologies, a three-dimensional (3D) printing technique has become one of the most important techniques under development. The 3D printing technique is also referred to as an additive manufacturing (AM) technique which is a type of rapid prototyping (RP) technique and can establish a 3D object through a layer-by-layer printing manner based on a digital forming drawing file by using bonding materials, such as powdered metals or plastic materials.

The print head of the current 3D printing apparatus is mainly comprised of a feeding tube, a heating device and a nozzle. Most of raw materials used are hot-melt forming materials. These forming materials are solid at room temperature. The solid forming material is transmitted to the nozzle through the feeding tube, hot-melted by the heating device and extruded from the nozzle, so as to form a 3D object layer by layer. Different materials have different characteristics, therefore the printing temperature for melting the forming material is usually default according to the type of the used material.

However, the default temperature cannot be suitable for printing every 3D object. For example, it is found that portions of a 3D object having large cross-sectional areas crack sometimes when using the material of Acrylonitrile Butadiene Styrene (ABS). Such deficiencies probably result from an improper printing temperature or printing speed when printing these portions. Accordingly, it would be helpful to provide a mechanism for curing such deficiencies.

US-A-20130297320 discloses a three-dimensional (3D) printing method and apparatus according to the preamble of claim 1 and 7, respectively, comprising a voice control for user interaction. The voice-controlled interface can enable a variety of voice-controlled functions and operations to set up printing parameters.

### SUMMARY

It is an object of the present invention to provide a three-dimensional (3D) printing method and apparatus, configured for easily adjusting printing the conditions during printing in accordance with different materials having different characteristics.

This problem is solved by a three-dimensional (3D) printing method and apparatus according as claimed by claim 1 and 7, respectively. Further advantageous embodiments are the subject-matter of the dependent claims.

The 3D printing method and a 3D printing apparatus using the 3D printing method of the present invention provides an opportunity for real-time controlling the printing temperature during a printing procedure.

Based on the above, the 3D printing method and the 3D printing apparatus provided in the embodiments of the invention is capable of adjusting the printing temperature during the printing procedure. Accordingly, convenience and flexibility of 3D printing can be improved. In addition, a user can real-time adjust the printing temperature as desired when his/her 3D object is being printing, thus the printing quality can be well-controlled.

In order to make the aforementioned and other features and advantages of the invention more comprehensible, several embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 illustrates a schematic block diagram of a three-dimensional printing apparatus according to an embodiment of the invention.
FIG. 2 illustrates a flowchart of a three-dimensional printing method according to an embodiment of the invention.
FIG. 3 illustrates a flowchart of obtaining the adjustment signal according to an embodiment of the invention.
FIG. 4 illustrates a schematic diagram of a prompt message displayed on a display according to an embodiment of the invention.

### DESCRIPTION OF EMBODIMENTS

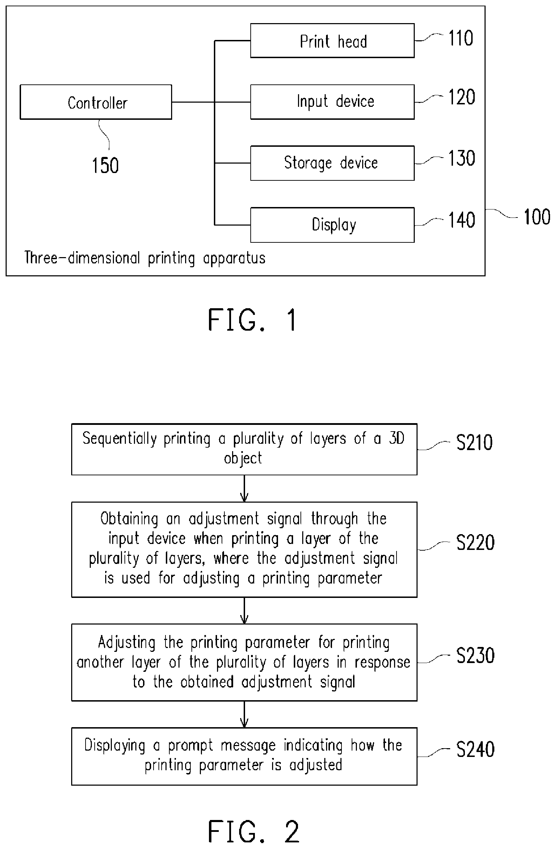

FIG. 1 illustrates a schematic block diagram illustrating a three-dimensional (3D) printing apparatus according to an embodiment of the invention. Referring to FIG. 1, a 3D printing apparatus 100 includes a print head 110, an input device 120, a storage device 130, a display 140, and a controller 150. The 3D printing apparatus 100 is, for example, a 3D printer that forms the 3D object layer by layer.

The print head 110 is, for example, a melting head, which heats a filament formed by a laminated material to a printing temperature, and sprays the laminated material in a melting state to form a 3D object layer by layer.

The input device 120 may receive at least one type of input signal. For example, the input device 120 may be one or a combination of: at least one physical button disposed on the 3D printing apparatus, a wireless transceiver, and an audio input such as a microphone, but which are not limited herein. In one embodiment of the invention, the input device 120 includes at least the audio input for receive voice signals so that the 3D printing apparatus 100 provides a function of voice control.

The storage device 130 may be any type of fixed or portable random access memory (RAM), read-only memory (ROM), flash memory, or similar components, or a combination of the above components, which is not limited herein. In one embodiment of the invention, the storage device 130 is configured to store a sequence of printing commands to be executed for printing the 3D object. In another embodiment of the invention that the 3D printing apparatus 100 provides the function of voice control, the storage device 130 further stores a database supporting the function of voice control. Details of the printing commands, the function of voice control and the database supporting the same will be illustrated in the following descriptions.

The display 140 provides information of the printing status. The display 140 may be, for example, a liquid-crystal display (LCD) disposed on the 3D printing apparatus 100. In some cases, the LCD is combined with the input device 120, such that the input device 120 and the display 140 can be implemented together as a touch screen.

The controller 150 is coupled to the print head 110, the input device 120, the storage device 130 and the display 140, and is in charge of the overall operations of the 3D printing apparatus 100. The controller 150 may be a programmable device for general purpose or special purpose, for example, a central processing unit (CPU), a microprocessor or an embedded controller.

In one embodiment of the invention, the controller 150 may transfer an original image file (e.g., .STL, .SCAD, .OBJ, .3DS, .AMF, etc.) depicting a 3D object to a G-code file including multiple rows of G-code, where each row of the G-code stands for a printing command of the print head 110. After that, the controller 150 may sequentially execute the printing commands (the rows of the G-code) to control the print head 110 for printing the 3D object. Exemplary example of some rows of the G-code are listed in Table. 1 below.

**Table. 1**

| Row No. | G-code | | | | |
|---|---|---|---|---|---|
| 60 | G1 | Z25.250 | F2700.000 | M104 S210 | |
| 61 | G1 | X82.000 | Y72.000 | F300.000 | E8 |
| 62 | G1 | X67.000 | Y77.000 | E10.68 | |
| 63 | G1 | X67.000 | Y72.000 | E11.15 | |
| 64 | G1 | Z25.550 | F2700.000 | | |
| 65 | G1 | X82.000 | Y72.000 | F300.000 | E8 |
| 66 | G1 | X67.000 | Y77.000 | E10.68 | |
| 67 | G1 | X67.000 | Y72.000 | E11.15 | |

As shown in Table. 1, the 3D printing apparatus 100 may sequentially execute multiple rows of the G-code named G1 in this embodiment. Each row of the G-code mainly includes a destination position of the print head 110.

Referring to the G-code of row No. 61, the field "F300.000" has the controller 150 control the print head 110 to move in a speed rate of 300 mm/min, namely, "F300.000" represents a printing parameter of "moving speed of the print head 110" with value of 300 mm/min. In some cases, a row of the G-code does not have the printing parameter of "moving speed" (e.g., "FXXX") of the print head 110, which indicates that the controller 150 does not change the moving speed of the print head 110 when executing the row of the G-code. As per the field "X82.000 Y72.000", it represents a destination coordinate (i.e., (82, 72)) where the print head 110 is finally located after the execution of the G-code of row No. 61 is completed, namely, "X82.000 Y72.000" represents a printing parameter of "location of the print head 110" with value of (82, 72). As per the field "E8", it has the controller 150 control the filament or material extruded from the print head 110 is 8 mm, namely, "E8" represents a printing parameter of "feeding amount of the print head 110" with value of 8 mm.

For instance, when the controller 150 executes the G-code of row No. 61, the print head 110 moves in the speed of 300 mm/min toward the destination coordinate (82, 72) and the material extruded from the print head 110 is 8 mm during the process of moving. In the same way, when the controller 150 executes the G-code of row No. 62, the print head 110 continues to move in the speed of 300 mm/min toward a destination coordinate (67, 77), and the material extruded from the print head 110 is 10.68 mm during the process of moving. In other words, 2.68 mm of the material is fed when the G-code of row No. 62 is executed by the controller 150.

Referring to the G-code of rows No. 60 and 64, the field "Z25.250" has the controller 150 lift the print head 110 to a specific height, and the field "Z25.500" has the controller 150 lift the print head 110 to another specific height. That is to say, the controller 150 prints one layer (e.g., the n^{th} layer) of the 3D object by executing the G-code of rows No. 60 to 63, and lifts the print head 110 to start printing a next layer (e.g., the (n+1)^{th} layer) of the 3D object when executing the G-code of row No. 64. Namely, "Z25.250" and "Z25.500" represents the printing parameter of "printing height" with values of 25.250 and 25.500. As per the field "M104 S210", it has the controller 150 control the print head 110 to heat the laminated material to a printing temperature of 210 Celsius degrees, namely, "M104 S210" represents a printing parameter of "printing temperature" with value of 210 °C.

In the embodiment, the printing parameter can be a "moving speed of the print head 110", a "location of the print head 110", a "feeding amount from the print head 110", a "printing height", or a "printing temperature", but which is not limited in the invention. In other embodiments, the printing parameter can be any other parameter that affects the printing procedure.

FIG. 2 illustrates a flowchart of a 3D printing method according to an embodiment of the invention. The 3D printing method may be performed by the 3D printing apparatus 100 of the embodiment of FIG. 1. Therefore, the 3D printing method may be illustrated by referring to the aforementioned 3D printing apparatus 100 in the present embodiment.

Referring to FIG. 1 and FIG. 2, in order to print a 3D object, the controller may sequentially print a plurality of layers of the 3D object (S210). To be specific, a 3D object may be formed by multiple layers. In one embodiment, the controller 150 may load a G-code file including multiple rows of the G-code (i.e., the printing commands), each printing command is corresponding to one single row of the G-code as described above. After that, the controller 150 starts the printing procedure and executes the printing commands sequentially. As mentioned before, the controller 150 may lift the print head 110 to start printing a next layer whenever a printing command adjusting the printing height is executed, such that the 3D object can be printed layer by layer. The G-code file may be, for example, originally stored in the storage device 130 or received from the input device 120, which is not limited in the invention.

During the printing procedure, the controller 150 obtains an adjustment signal through the input device 120 when printing a specific layer of the 3D object (S220). To be specific, the adjustment signal is used for adjusting a printing parameter of the printing procedure. As such, the adjustment signal includes information of a printing parameter specifically indicating what is being adjusted, and an adjustment behavior of the printing parameter specifically indicating how the printing parameter is adjusted. For example, an adjustment signal may be used for rising the printing temperature that the print head 110 heats the laminated material. In this case, the adjustment signal should be corresponding to the printing parameter of "printing temperature", meanwhile corresponding to the adjustment behavior of "increase".

In one embodiment, user may generate the adjustment signal by at least one physical or virtual button disposed on the 3D printing apparatus 100, therefore the adjustment signal may be received through the at least one physical or virtual button. In one embodiment, user may generate a wireless signal by using a remote controller, and the wireless signal may be received through a wireless transceiver of the 3D printing apparatus 100 and transferred to the adjustment signal by the controller 150.

Advantageously, user may generate the adjustment signal through the voice in one embodiment of the invention, a voice signal generated by the user may be received through an audio input (e.g., a microphone) of the 3D printing apparatus 100 and be transferred to the adjustment signal by the controller 150 using technologies such as semantic analysis. In one embodiment, for supporting the function of voice control, the storage device 130 stores a database that records, for example, multiple nouns and the printing parameter corresponding to each noun. As per each of the nouns, the database records multiple verbs and the adjustment behavior corresponding to each verb.

For example, for the noun "temperature" corresponding to the printing parameter "printing temperature", the verbs "rise" and "increase" may both correspond to the adjustment behavior "increase", and the verbs "drop" and "decrease" may both correspond to the adjustment behavior "decrease". In such case, when "temperature" and "rise" are extracted from a voice signal, which means that the value of the printing parameter "printing temperature" will be increased accordingly.

For another example, for the noun "speed" corresponding to the printing parameter "moving speed of the print head 110", the verbs "rise" and "increase" may both correspond to the adjustment behavior "increase", and the verbs "drop" and "decrease" may both correspond to the adjustment behavior "decrease". In such case, when "speed" and "rise" are extracted from a voice signal, which means that the value of the printing parameter "moving speed of the print head 110" will be increased accordingly.

For still another example, for the noun "retract length" corresponding to the printing parameter "feeding amount from the print head 110", the verb "rise" and "increase" may both correspond to the adjustment behavior "decrease", and the verbs "drop" and "decrease" may both correspond to the adjustment behavior "increase". In such case, when "retract length" and "increase" are extracted from a voice signal, which means that the value of the printing parameter "feeding amount from the print head 110" will be decreased accordingly.

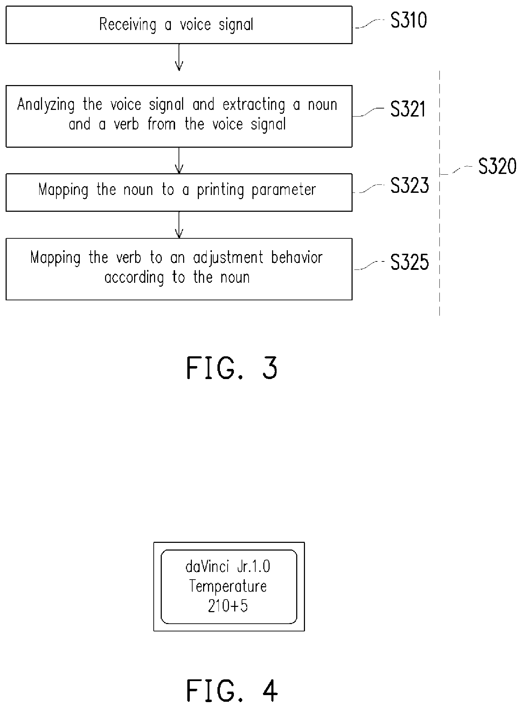

FIG. 3 illustrates a flowchart of obtaining the adjustment signal according to an embodiment of the invention. Referring to FIG. 3, the controller 150 receives a voice signal through the input device 120 (S310), then transfers the voice signal to an adjustment signal (S320).

To be specific, after receiving the voice signal, the controller 150 may analyze the voice signal and to extract a noun and a verb from the voice signal (S321). For example, the received voice signal says "temperature rises". The controller 150 may perform a semantic analysis on the voice signal to extract the noun "temperature" and the verb "rise" from the voice signal. For another example, the received voice signal says "rise the speed, please". The controller 150 may perform a semantic analysis on the voice signal to extract the noun "speed" and the verb "rise" from the voice signal. For still another example, the received voice signal says "increase the retract length". The controller 150 may perform a semantic analysis on the voice signal to extract the noun "retract length" and the verb "increase" from the voice signal.

Subsequently, the controller 150 may map the noun to a printing parameter (S323), and map the verb to an adjustment behavior according to the noun (S325). For example, regarding the extracted "temperature" and "rise", the controller 150 may consult a database stored in the storage device 130, map the "temperature" to the printing parameter "printing temperature", and map the "rise" to the adjustment behavior "increase". As a result, an adjustment signal used for rising the printing temperature is thus transferred from the voice signal. For another example, regarding the extracted "speed" and "rise", the controller 150 may consult a database stored in the storage device 130, map the "speed" to the printing parameter "moving speed of the print head 110", and map the "rise" to the adjustment behavior "increase". As a result, an adjustment signal used for increasing the moving speed of the printing head 110 is thus transferred from the voice signal. For still another example, regarding the extracted "retract length" and "increase", the controller 150 may consult a database stored in the storage device 130, map the "retract length" to the printing parameter "feeding amount from the print head 110", and map the "increase" to the adjustment behavior "decrease". As a result, an adjustment signal used for increase the retract length is thus transferred from the voice signal.

It is noted that the embodiment of FIG. 3 is mere an exemplary embodiment, and how the voice signal is transferred to the adjustment signal is not limited in the invention. In another embodiment, the database may further record comparative adjectives such as "faster" or "slower", and each comparative adjective may correspond to an adjustment behavior. In still another embodiment, the database may further record nouns composed of a number and a unit, such as "5 mm/sec" or "10 °C", and each noun may correspond to an adjustment behavior as well. One skilled in the art can obtain enough knowledge of how to transfer a voice signal to an adjustment signal for adjusting the printing parameter by the controller 150, which is not repeatedly described in the description.

Referring back to FIG. 2, in response to the obtained adjustment signal, the controller 150 may adjust a specific printing parameter for printing another layer of the plurality of layers (S230), where information of the specific printing parameter is in the obtained adjustment signal as mentioned before. For providing the printing status, the controller 150 may display a prompt message on the display 140 when the printing parameter is adjusted (S240), where the prompt message indicates how the printing parameter is adjusted.

In one embodiment, the adjustment signal may be used for adjusting a printing temperature and obtained when the controller 150 is printing the n^{th} layer of the plurality of layers of the 3D object, where n is a natural number. In response to the obtained adjustment signal that adjusts the printing temperature, the controller 150 may adjust the printing parameter "printing temperature" for printing the (n+1)^{th} layer of the plurality of layers of the 3D object according to the adjustment signal, and display a prompt message since any printing parameter is adjusted.

For descriptive convenience, the G-code listed in Table. 1 is taken as an example:

**Table. 1**

| Row No. | G-code | | | | |
|---|---|---|---|---|---|
| 60 | G1 | Z25.250 | F2700.000 | M104 S210 | |
| 61 | G1 | X82.000 | Y72.000 | F300.000 | E8 |
| 62 | G1 | X67.000 | Y77.000 | E10.68 | |
| 63 | G1 | X67.000 | Y72.000 | E11.15 | |
| 64 | G1 | Z25.550 | F2700.000 | | |
| 65 | G1 | X82.000 | Y72.000 | F300.000 | E8 |
| 66 | G1 | X67.000 | Y77.000 | E10.68 | |
| 67 | G1 | X67.000 | Y72.000 | E11.15 | |

In this embodiment, an adjustment signal for increasing the printing temperature is obtained when the controller 150 is executing the G-code of row No. 62 (i.e., the 62^{th} command) for printing the n^{th} layer of the 3D object. In response thereto, the controller 150 may find the G-code of row No. 64 (i.e., the 64^{th} command) having the printing parameter of "printing height" (i.e., Z25.500) that lifts the print head 110 and starts to print the (n+1)^{th} layer of the object, then insert the printing parameter "printing temperature" into the found printing command (i.e., the 64^{th} command). For example, the printing parameter of "printing temperature" is set to increase/decrease ±5 °C in response to one adjustment signal with adjustment behavior of "increase/decrease" in the embodiment. Accordingly, the G-code will be adjusted as listed in Table. 2 shown below. In this embodiment, a preset range (e.g., 170 °C to 240 °C) of the printing temperature is default in the controller 150. Therefore, the printing parameter of "printing temperature" is confined within the range of "M104 S170" to "M104 S240", such that the temperature that the print head 110 heats the laminated material is confined within 170 °C to 240 °C.

**Table. 2**

| Row No. | G-code | | | | |
|---|---|---|---|---|---|
| 60 | G1 | Z25.250 | F2700.000 | M104 S210 | |
| 61 | G1 | X82.000 | Y72.000 | F300.000 | E8 |
| 62 | G1 | X67.000 | Y77.000 | E10.68 | |
| 63 | G1 | X67.000 | Y72.000 | E11.15 | |
| 64 | G1 | Z25.550 | F2700.000 | M104 S215 | |
| 65 | G1 | X82.000 | Y72.000 | F300.000 | E8 |
| 66 | G1 | X67.000 | Y77.000 | E10.68 | |
| 67 | G1 | X67.000 | Y72.000 | E11.15 | |

As shown in Table. 2, the "M104 S215" is inserted into the G-code of row No. 64 in response to the adjustment signal, since the G-code of row No. 64 is for printing a next layer of the 3D object. As a result, the print head 110 would heat the laminated material to 215 °C when the controller 150 executes the G-code of row No. 64, and the prompt message would be displayed on the display 140 as shown in FIG. 4.

In summary, by adopting the 3D printing method and 3D printing apparatus provided in the embodiments of the invention, the printing parameters, such as printing temperature, can be adjusted during the printing procedure. Accordingly, convenience and flexibility of 3D printing can be improved. For instance, a portion of an object to be printed has a larger cross-sectional area, while another portion of the object has a smaller cross-sectional area. Therefore, the print head can heat the laminated material to a higher temperature when printing the portion having the larger cross-sectional area, and heat the laminated material to a lower temperature when printing the portion having the smaller cross-sectional area. Thus, the printing quality can be well-controlled. Additionally, the function of voice control is provided in one embodiment of the invention. By using the function of voice control, the users may conveniently and real-time adjust the printing parameters during the printing procedure as desired.

## Claims

1. A three-dimensional (3D) printing method for forming a 3D object layer by layer, applicable to a 3D printing apparatus (100) comprising an input device (120), comprising:
sequentially printing a plurality of layers of the 3D object;
obtaining an adjustment signal through the input device (120) when printing a layer of the plurality of layers, wherein the adjustment signal is used for adjusting a printing parameter; and
adjusting the printing parameter for printing another layer of the plurality of layers in response to the obtained adjustment signal, wherein obtaining the adjustment signal through the input device (120) comprises:
receiving a voice signal; and
transferring the voice signal to the adjustment signal;
**characterized in that** the adjustment signal is obtained through the input device (120) when printing the layer of the plurality of layers, wherein the obtained adjustment signal is used for adjusting a printing temperature, and the printing temperature is confined within a preset range; wherein
obtaining the adjustment signal through the input device (120) when printing the layer of the plurality of layers comprises:
obtaining the adjustment signal through the input device (120) when printing the n^{th} layer of the plurality of layers, and
wherein adjusting the printing temperature for printing the another layer of the plurality of layers in response to the obtained adjustment signal comprises:
adjusting the printing temperature for printing the (n+1)^{th} layer of the plurality of layers according to the adjustment signal, wherein n is a natural number.

2. The 3D printing method as claimed in claim 1, further comprising:
displaying a prompt message on a display (140) when the printing temperature is adjusted.

3. The 3D printing method as claimed in claim 1 or 2, wherein transferring the voice signal to the adjustment signal comprises:
analyzing the voice signal and extracting a noun and a verb from the voice signal;
mapping the noun to the printing parameter;
mapping the verb to an adjustment behavior according to the noun.

4. The 3D printing method as claimed in claim 3, wherein adjusting the printing parameter when printing the another layer of the plurality of layers in response to the obtained adjustment signal comprises:
adjusting the mapped printing parameter for printing the another layer of the plurality of layers according to the mapped adjustment behavior.

5. The 3D printing method as claimed in any of the preceding claims, wherein the printing parameter further comprises a moving speed of a print head (110) and/or a location of the print head (110) and/or a feeding amount from the print head (110) and/or a printing height,

6. The 3D printing method as claimed in any of the preceding claims, wherein each of the printing commands corresponds to a single row of G-code.

7. A three-dimensional (3D) printing apparatus (100), comprising:
a print head (110), configured to form a 3D object layer by layer;
an input device (120) for receiving a voice signal; and
a controller (150), coupled to the print head (110) and the input device (120), and configured to sequentially printing a plurality of layers of the 3D object by the print head (110) and to obtain an adjustment signal through the input device (120) by transferring the voice signal to the adjustment signal when printing a layer of the plurality of layers, and to adjust a printing parameter for printing another layer of the plurality of layers in response to the obtained adjustment signal;
**characterized in that** the controller (150) is configured for obtaining the adjustment signal through the input device (120) when printing the layer of the plurality of layers, wherein the obtained adjustment signal is used for adjusting a printing temperature, wherein a preset range of the printing temperature is default in the controller (150), and the controller (150) confines the printing temperature within the preset range;
wherein the controller (150) is configured to receive the adjustment signal when printing the n^{th} layer of the plurality of layers and to adjust the printing temperature for printing the (n+1)^{th} layer of the plurality of layers according to the adjustment signal, wherein n is a natural number.

8. The 3D printing apparatus (100) as claimed in claim 7, further comprising:
a display (140) coupled to the controller (150), configured to display a prompt message when the printing temperature is adjusted.

9. The 3D printing apparatus (100) as claimed in claim 7 or 8, further comprising:
a storage device (130) coupled to the controller (150), configured to store a database, wherein the database comprises a plurality of nouns, each noun corresponds to a printing parameter and a plurality of verbs, and each verb corresponds to an adjustment behavior,
wherein the controller (150) analysis the voice signal and extracts a noun and a verb from the voice signal, wherein the controller (150) further consults the database to map the extracted noun to the printing parameter, and to map the extracted verb to the adjustment behavior according to the noun.

10. The 3D printing apparatus (100) as claimed in any of claims 7 to 9, wherein the printing parameter further comprises a moving speed of a print head (110) and/or a location of the print head (110) and/or a feeding amount of the print head (110) and/or a printing height.

11. The 3D printing apparatus (100) as claimed in any of claims 7 to 10, wherein each of the printing commands corresponds to a single row of G-code.

## Patentansprüche

1. Dreidimensionales (3D) Druckverfahren zum schichtweisen Erzeugen eines 3D-Objekts, anwendbar auf eine 3D-Druckvorrichtung (100) mit einer Eingabevorrichtung (120), umfassend:
sequentielles Drucken einer Vielzahl von Schichten des 3D-Objekts;
Erhalten eines Einstellsignals durch die Eingabevorrichtung (120), wenn eine Schicht der Vielzahl von Schichten gedruckt wird, wobei das Einstellsignal zum Einstellen eines Druckparameters verwendet wird; und
Einstellen des Druckparameters zum Drucken einer weiteren Schicht der Vielzahl von Schichten in Antwort auf das erhaltene Einstellsignal, wobei das Erhalten des Einstellsignals durch die Eingabevorrichtung (120) umfasst:
Empfangen eines Sprachsignals; und
Übertragung des Sprachsignals auf das Einstellsignal;
**dadurch gekennzeichnet, dass** das Einstellsignal durch die Eingabevorrichtung (120) erhalten wird, wenn die Schicht der Vielzahl von Schichten gedruckt wird, wobei das erhaltene Einstellsignal zum Einstellen einer Drucktemperatur verwendet wird, und wobei die Drucktemperatur innerhalb eines voreingestellten Bereichs begrenzt ist; wobei
das Erhalten des Einstellsignals durch die Eingabevorrichtung (120) beim Drucken der Schicht der Vielzahl von Schichten umfasst:
Erhalten des Einstellsignals durch die Eingabevorrichtung (120), wenn die n-te Schicht der Vielzahl von Schichten gedruckt wird, und
wobei das Einstellen der Drucktemperatur zum Drucken der anderen Schicht der Vielzahl von Schichten in Antwort auf das erhaltene Einstellsignal umfasst:
Einstellen der Drucktemperatur zum Drucken der (n+1)-ten Schicht der Vielzahl von Schichten gemäß dem Einstellsignal, wobei n eine natürliche Zahl ist.

2. 3D-Druckverfahren nach Anspruch 1, weiterhin umfassend:
Anzeigen einer Aufforderungsmeldung auf einer Anzeige (140), wenn die Drucktemperatur eingestellt wird.

3. 3D-Druckverfahren nach Anspruch 1 oder 2, wobei die Übertragung des Sprachsignals auf das Anpassungssignal umfasst:
Analysieren des Sprachsignals und Extrahieren eines Substantivs und eines Verbs aus dem Sprachsignal;
Abbilden des Substantivs auf den Druckparameter;
Abbilden des Verbs auf ein Einstellverhalten gemäß dem Substantiv.

4. 3D-Druckverfahren nach Anspruch 3, wobei das Einstellen des Druckparameters beim Drucken der anderen Schicht der Vielzahl von Schichten in Antwort auf das erhaltene Anpassungssignal umfasst:
Einstellen des abgebildeten Druckparameters zum Drucken der anderen Schicht der Vielzahl von Schichten gemäß dem abgebildeten Einstellverhalten.

5. 3D-Druckverfahren nach einem der vorhergehenden Ansprüche, wobei der Druckparameter weiterhin eine Bewegungsgeschwindigkeit eines Druckkopfes (110) und/oder eine Position des Druckkopfes (110) und/oder eine Vorschubgröße des Druckkopfs (110) und/oder eine Druckhöhe umfasst.

6. 3D-Druckverfahren nach einem der vorhergehenden Ansprüche, wobei jeder der Druckbefehle einer einzelnen Zeile eines G-Codes entspricht.

7. Dreidimensionale (3D) Druckvorrichtung (100), umfassend:
einen Druckkopf (110), der so konfiguriert ist, dass er schichtweise ein 3D-Objekt erzeugt;
eine Eingabevorrichtung (120) zum Empfangen eines Sprachsignals; und
einen Controller (150), der mit dem Druckkopf (110) und der Eingabevorrichtung (120) gekoppelt ist und konfiguriert ist, um sequentiell eine Vielzahl von Schichten des 3D-Objekts mit Hilfe des Druckkopfs (110) zu drucken und um ein Einstellsignal über die Eingabevorrichtung (120) zu erhalten, indem das Sprachsignal auf das Einstellsignal übertragen wird, wenn eine Schicht der Vielzahl von Schichten gedruckt wird, und um einen Druckparameter zum Drucken einer anderen Schicht der Vielzahl von Schichten in Antwort auf das erhaltene Einstellsignal einzustellen;
**dadurch gekennzeichnet, dass** der Controller (150) so konfiguriert ist, dass dieser das Einstellsignal über die Eingabevorrichtung (120) erhält, wenn die Schicht von der Vielzahl von Schichten gedruckt wird, wobei das erhaltene Einstellsignal zum Einstellen einer Drucktemperatur verwendet wird, wobei ein voreingestellter Bereich der Drucktemperatur in dem Controller (150) voreingestellt ist und der Controller (150) die Drucktemperatur innerhalb des voreingestellten Bereichs begrenzt;
wobei der Controller (150) konfiguriert ist, um das Einstellsignal zu empfangen, wenn die n-te Schicht der Vielzahl von Schichten gedruckt wird, und um die Drucktemperatur zum Drucken der (n+1)-ten Schicht der Vielzahl von Schichten gemäß dem Einstellsignal einzustellen, wobei n eine natürliche Zahl ist.

8. 3D-Druckvorrichtung (100) nach Anspruch 7, weiterhin umfassend:
eine mit dem Controller (150) gekoppelte Anzeige (140), die so konfiguriert ist, dass diese eine Aufforderungsmeldung anzeigt, wenn die Drucktemperatur eingestellt wird.

9. 3D-Druckvorrichtung (100) nach Anspruch 7 oder 8, weiterhin umfassend:
eine mit dem Controller (150) gekoppelte Speichervorrichtung (130), die so konfiguriert ist, dass diese eine Datenbank speichert, wobei die Datenbank eine Vielzahl von Substantiven umfasst, jedes Substantiv einem Druckparameter und einer Vielzahl von Verben entspricht und jedes Verb einem Einstellverhalten entspricht,
wobei der Controller (150) das Sprachsignal analysiert und ein Substantiv und ein Verb aus dem Sprachsignal extrahiert, wobei der Controller (150) weiterhin die Datenbank einsetzt, um das extrahierte Substantiv auf den Druckparameter abzubilden und um das extrahierte Verb gemäß dem Substantiv auf das Einstellverhalten abzubilden.

10. 3D-Druckvorrichtung (100) nach einem der Ansprüche 7 bis 9, wobei der Druckparameter weiterhin eine Bewegungsgeschwindigkeit eines Druckkopfes (110) und/oder eine Position des Druckkopfes (110) und/oder eine Vorschubgröße des Druckkopfes (110) und/oder eine Druckhöhe umfasst.

11. 3D-Druckvorrichtung (100) nach einem der Ansprüche 7 bis 10, wobei jeder der Druckbefehle einer einzelnen Zeile eines G-Codes entspricht.

## Revendications

1. Procédé d'impression tridimensionnelle (3D) pour former un objet 3D couche par couche, applicable à un appareil d'impression 3D (100) comprenant un dispositif d'entrée (120), comprenant :
imprimer séquentielle d'une pluralité de couches de l'objet 3D;
obtenir d'un signal d'ajustement par l'intermédiaire du dispositif d'entrée (120) lors de l'impression d'une couche de la pluralité de couches, dans lequel le signal d'ajustement est utilisé pour ajuster un paramètre d'impression; et
ajuster le paramètre d'impression pour imprimer une autre couche de la pluralité de couches en réponse au signal d'ajustement obtenu, dans lequel l'obtention du signal d'ajustement par le dispositif d'entrée (120) comprend:
recevoir un signal vocal; et
transferir le signal vocal vers le signal d'ajustement;
**caractérisé en ce que** le signal d'ajustement est obtenu par l'intermédiaire du dispositif d'entrée (120) lors de l'impression de la couche de la pluralité de couches, dans lequel le signal d'ajustement obtenu est utilisé pour ajuster une température d'impression, et la température d'impression est confinée dans une étendue préétablie; dans lequel
obtenir le signal d'ajustement par le dispositif d'entrée (120) lors de l'impression de la couche de la pluralité de couches comprend:
obtenir le signal d'ajustement par l'intermédiaire du dispositif d'entrée (120) lors de l'impression de la nième couche de la pluralité de couches, et
dans lequel l'ajustement de la température d'impression pour l'impression de l'autre couche de la pluralité de couches en réponse au signal d'ajustement obtenu comprend:
ajuster la température d'impression pour imprimer la (n+1)ème couche de la pluralité de couches en réponse du signal d'ajustement, où n est un nombre naturel.

2. Le procédé d'impression 3D selon la revendication 1, comprenant en outre:
présenter un message d'invite sur un écran (140) lorsque la température d'impression est ajustée.

3. Le procédé d'impression 3D selon la revendication 1 ou 2, dans lequel transferir le signal vocal au signal d'ajustement comprend :
analyser le signal vocal et extrahir un nom et d'un verbe du signal vocal;
metre en correspondance le nom avec le paramètre d'impression;
metre en correspondance du verbe avec un comportement d'ajustement en réponse du nom.

4. Le procédé d'impression 3D selon la revendication 3, dans lequel ajuster le paramètre d'impression lors de l'impression d'une autre couche de la pluralité de couches en réponse au signal d'ajustement obtenu comprend:
ajuster le paramètre d'impression mappé pour l'impression de l'autre couche de la pluralité de couches en réponse du comportement d'ajustement mappé.

5. Le procédé d'impression d'impression 3D selon qeulconque des revendications précédentes, dans lequel le paramètre d'impression comprend en outre une vitesse de déplacement d'une tête d'impression (110) et/ou un emplacement de la tête d'impression (110) et/ou une quantité d'alimentation de la tête d'impression (110) et/ou une hauteur d'impression.

6. Le procédé d'impression d'impression 3D dselon quelconque des revendications précédentes, dans lequel chacune des commandes d'impression correspond à une seule ligne de code G.

7. Un appareil d'impression tridimensionnelle (3D) (100), comprenant:
une tête d'impression (110), configurée pour former un objet 3D couche par couche;
un dispositif d'entrée (120) pour recevoir un signal vocal; et
un contrôleur (150), couplé à la tête d'impression (110) et au dispositif d'entrée (120), et configuré pour imprimer séquentiellement une pluralité de couches de l'objet 3D par la tête d'impression (110) et pour obtenir un signal d'ajustement par l'intermédiaire du dispositif d'entrée (120) en transférant le signal vocal au signal d'ajustement lors de l'impression d'une couche de la pluralité de couches, et pour ajuster un paramètre d'impression pour l'impression d'une autre couche de la pluralité de couches en réponse au signal d'ajustement obtenu;
**caractérisé en ce que** le contrôleur (150) est configuré pour obtenir le signal d'ajustement par l'intermédiaire du dispositif d'entrée (120) lors de l'impression de la couche de la pluralité de couches, dans lequel le signal d'ajustement obtenu est utilisé pour ajuster une température d'impression, dans lequel une étendue préétablie de la température d'impression est par défaut dans le contrôleur (150), et le contrôleur (150) confine la température d'impression dans la étendue préétablie;
dans lequel le contrôleur (150) est configuré pour recevoir le signal d'ajustement lors de l'impression de la nième couche de la pluralité de couches et pour ajuster la température d'impression pour l'impression de la (n+1)ième couche de la pluralité de couches en réponse du signal d'ajustement, dans lequel n est un nombre naturel.

8. L'appareil d'impression 3D (100) selon la revendication 7, comprenant en outre:
un écran (140) couplé au contrôleur (150), configuré pour présenter un message d'invite lorsque la température d'impression est ajustée.

9. L'appareil d'impression 3D (100) selon la revendication 7 ou 8, comprenant en outre: un écran (140) couplé au contrôleur (150), configuré pour présenter un message d'invite lorsque la température d'impression est ajustée:
un dispositif de stockage (130) couplé au contrôleur (150), configuré pour stocker une base de données, dans lequel la base de données comprend une pluralité de noms, chaque nom correspond à un paramètre d'impression et une pluralité de verbes, et chaque verbe correspond à un comportement d'ajustement,
dans lequel le contrôleur (150) analyse le signal vocal et extrait un nom et un verbe du signal vocal, dans lequel le contrôleur (150) consulte en outre la base de données pour mettre en correspondance le nom extrait avec le paramètre d'impression, et pour mettre en correspondance le verbe extrait avec le comportement de réglage en réponse du nom.

10. L'appareil d'impression 3D (100) selon quelconque des revendications 7 à 9, dans lequel le paramètre d'impression comprend en outre une vitesse de déplacement d'une tête d'impression (110) et/ou un emplacement de la tête d'impression (110) et/ou une quantité d'alimentation de la tête d'impression (110) et/ou une hauteur d'impression.

11. L'appareil d'impression 3D (100) selon quelconque des revendications 7 à 10, dans lequel chacune des commandes d'impression correspond à une seule ligne de code G.
